(19) Europäisches Patentamt
European Patent Office
Office européen des brevets

(11) **EP 3 495 765 B1**

(12) **EUROPÄISCHE PATENTSCHRIFT**

(45) Veröffentlichungstag und Bekanntmachung des Hinweises auf die Patenterteilung:
**29.09.2021   Patentblatt 2021/39**

(51) Int Cl.:
**G01B 7/06** (2006.01)   *G01B 21/04* (2006.01)

(21) Anmeldenummer: **18200758.3**

(22) Anmeldetag: **16.10.2018**

(54) **VERFAHREN UND VORRICHTUNG ZUR MESSUNG DER DICKE VON NICHT MAGNETISIERBAREN SCHICHTEN AUF EINEM MAGNETISIERBAREN GRUNDWERKSTOFF**

METHOD AND DEVICE FOR MEASURING THE THICKNESS OF NON-MAGNETIZABLE LAYERS ON A MAGNETIZABLE BASE MATERIAL

PROCÉDÉ ET DISPOSITIF DE MESURE DE L'ÉPAISSEUR DES COUCHES NON MAGNÉTISABLES SUR UN MATÉRIAU DE BASE MAGNÉTISABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.12.2017   DE 102017129150**

(43) Veröffentlichungstag der Anmeldung:
**12.06.2019   Patentblatt 2019/24**

(73) Patentinhaber: **Helmut Fischer GmbH Institut für Elektronik und Messtechnik
71069 Sindelfingen (DE)**

(72) Erfinder:
• **Vollmar, Hans-Peter
  70599 Stuttgart (DE)**
• **Wersal, Helmut
  71069 Sindelfingen (DE)**

(74) Vertreter: **Mammel und Maser
Patentanwälte
Tilsiter Straße 3
71065 Sindelfingen (DE)**

(56) Entgegenhaltungen:
DE-A1- 4 119 903        DE-A1- 19 628 220
DE-T2- 60 018 341       GB-A- 645 777
JP-A- H11 142 577       US-A- 5 648 721

EP 3 495 765 B1

**Beschreibung**

Die Erfindung betrifft ein Verfahren und eine Vorrichtung zur Messung der Dicke von nicht-magnetisierbaren Schichten auf einem magnetisierbaren Grundwerkstoff, dessen Permeabilität nicht bekannt ist.

Aus der DE 33 31 407 C2 ist eine Messsonde zur Messung der Dicke dünner Schichten bekannt. Eine solche Messsonde weist einen Sondenkopf auf, welcher einen Topfkern aus Weicheisen umfasst, der rotationssymmetrisch zu einer geometrischen Achse ausgebildet ist. Der Topfkern nimmt an einem inneren Kern eine erste und zweite Spule auf. An einer Stirnseite ist der innere Kern als Messpol mit einer Aufsetzfläche auf einer zu messenden Schicht eines magnetisierbaren Grundwerkstoffes ausgebildet. Durch diese Messsonde wird die Ermittlung einer nicht magnetisierbaren Schicht auf einem magnetisierbaren Grundwerkstoff durch ein magnetinduktives Messverfahren ermöglicht.

Aus der DE 10 2005 054 593 A1 ist auch eine Messsonde zur Messung der Dicke dünner Schichten bekannt, welche einen Sondenkopf aufweist, der einen Topfkern mit einer ersten und einer zweiten Spule aufnimmt. Diese erste und zweite Spule stellt ein erstes Spulenpaar dar, die auf einer gemeinsamen geometrischen Achse liegen. An dem Topfkern und in der geometrischen Achse ist des Weiteren eine Aufsetzkalotte vorgesehen. Der Sondenkopf ist an einem federnd nachgiebig ausgebildeten Halteelement, insbesondere einer Membran, gegenüber einem Gehäuse gelagert. Während dem Aufsetzen der Messsonde auf der Oberfläche der zu messenden Schicht kann der Sondenkopf in das Gehäuse der Messsonde geringfügig entlang der Längsachse des Gehäuses eintauchen. Die von dem Sondenkopf ermittelten Messsignale werden an eine Auswerteeinheit weitergeleitet, um eine Schichtdicke zu ermitteln und auszugeben. Eine solche Messsonde kann zur magnetinduktiven Messung von Schichtdicken eingesetzt werden, das heißt, dass eine Messung der Dicke von nicht magnetisierbaren Schichten auf einem magnetisierbaren Grundwerkstoff erfolgt.

Aus der DE 41 19 903 A1 ist eine Messvorrichtung zur Messung dünner Schichten sowie ein Verfahren zur Messung dünner Schichten mit einer solchen Vorrichtung bekannt. Diese Vorrichtung umfasst eine Sonde mit einer ersten und einer zweiten Spulenvorrichtung, die koaxial zu einem gemeinsamen Kern angeordnet sind.

Aus der DE 43 25 767 A1 ist des Weiteren eine Schichtdickenmessvorrichtung bekannt, welche einen Kern umfasst, der hintereinander gereiht eine erste und zweite elektromagnetische Spule aufnimmt. Ein analoger Aufbau ist aus der DE 24 10 047 A1 bekannt.

Aus der US 5 648 721 A ist eine rotierende Magnetflussfokussierung für eine Wirbelstromsonde bekannt.

Die DE 600 18 341 T2 offenbart ein Verfahren zur Messung der Dicke einer Schicht eines ferromagnetischen Materials, das auf der Oberfläche eines Brennstabes ausgebildet ist. Die Messsonde umfasst einen Wirbelstromsensor, bei dem eine Spule mittels einem Wechselstrom erregt wird. Es erfolgt die Messung eines ersten komplexen Scheinwiderstandes durch den Fühler, der repräsentativ für die Veränderung der Permeabilität und die Veränderung der Dicke sowie für die Veränderung der Leitfähigkeit der Schicht aus ferromagnetischem Material ist.

Die JP H11 142 577 A offenbart eine zerstörungsfreie Messung einer magnetischen Schicht auf einen Oxidfilm durch eine Sonde. Dabei wird eine Schichtdicke ermittelt, indem ein Ausgabewert einer Messvorrichtung auf Basis eines Ausgabewertes von einer Messvorrichtung zur Ermittlung der Permeabilität korrigiert und ermittelt wird.

Aus der DE 196 28 220 A1 ist ein Verfahren und eine Vorrichtung zur Bestimmung der Dicke von Schichten auf einem Substrat bekannt. Dabei wird ein elektromagnetisches Wechselfeld erzeugt. Die Dicke der Schicht wird auf einer Grundlage der Ergebnisse von Messungen und Informationen über mindestens einige der elektromagnetischen Eigenschaften des Substrats und der Schicht berechnet.

Die GB 645 777 A umfasst eine Messvorrichtung zur Messung der Dicke von nicht-magnetischen Schichten auf einem magnetischen Material. Diese Vorrichtung weist einen U-förmigen Magnetkern auf, an dem eine erste und zweite Spule vorgesehen ist.

In Vorbereitung auf eine solche magnetinduktive Messung werden die Messsonden auf den magnetisierbaren Grundwerkstoff kalibriert. Eine solche Kalibrierung erfolgt durch unmittelbares Positionieren der Messsonde auf dem Grundwerkstoff, der ohne eine Beschichtung zur Kalibrierung bereitgestellt ist, und auf einen mit einer Schicht versehenen Grundwerkstoff.

Bei einer Vielzahl von Anwendungen, wie beispielsweise einer Schichtdickenmessung von Lacken auf Blechen in der Automobilindustrie, ist zwar grundsätzlich der zum Einsatz kommende Grundwerkstoff, jedoch nicht dessen exakte Permeabilität bekannt. Dadurch kann es zu Messungenauigkeiten kommen, sofern die Permeabilität des Grundwerkstoffes von dem zu messenden Material von der Permeabilität des zur Kalibrierung verwendeten Grundwerkstoffes abweicht.

Zudem werden vermehrt Messungen der Schichtdicke auf bereits beschichteten Grundwerkstoffen erforderlich, ohne dass die Möglichkeit besteht, die Messsonde vor den Messungen unmittelbar auf dem Grundwerkstoff ohne Beschichtung aufzusetzen und zu kalibrieren.

Der Erfindung liegt die Aufgabe zugrunde, ein Verfahren und eine Messsonde zur magnetinduktiven Messung der Schichtdicke von nicht magnetisierbaren Schichten auf einem beschichteten, magnetisierbaren Grundwerkstoff vorzuschlagen, dessen Permeabilität von den zur Kalibrierung verwendeten Grundwerkstoffen abweicht oder nicht bekannt ist, ohne dass daraus ein Messfehler in der Schichtdickenmessung resultiert.

Diese Aufgabe wird durch ein Verfahren gemäß des Anspruchs 1 gelöst, bei dem eine Messsonde eingesetzt wird, welche ein erstes Spulenpaar mit einer ersten und zweiten Spule aufweist, die einem Topfkern zugeordnet sind und in einer gemeinsamen geometrischen Achse liegen sowie dem ersten Spulenpaar außerhalb des Topfkernes ein zweites Spulenpaar mit einer ersten und zweiten Spule zugeordnet ist, wobei durch das erste Spulenpaar mit der Feldfokussierung ein erstes Wechselwirkungsvolumen erfasst wird und durch das zweite Spulenpaar ohne Feldfokussierung ein Wechselwirkungsvolumen erfasst wird und das erste und zweite Wechselwirkungsvolumen, insbesondere erste und zweite Messsignale des ersten und zweiten Spulenpaars, in einer Auswerteeinrichtung zur Kompensation einer Permeabilität des beschichteten magnetischen Grundwerkstoffs verglichen und eine um den Permeabilitätseinfluss des Grundwerkstoffs korrigierte Schichtdicke ausgegeben wird. Dieses Verfahren ermöglicht durch die Kompensation der Permeabilität des Grundwerkstoffes eine hohe Messgenauigkeit. Zudem kann die Schichtdickenmessung ohne die vorherige exakte Kenntnis des verwendeten Grundwerkstoffes durchgeführt werden. Insbesondere ist ein Verfahren zur Messung der Dicke von nicht magnetisierbaren Schichten auf einem unbekannten magnetisierbaren Grundwerkstoff vorgesehen. Auch kann der Einfluss der Permeabilität des beschichteten Grundwerkstoffes durch beispielsweise abweichende Legierungsbestandteile oder abweichende Herstellungs- und Bearbeitungsvorgänge gegenüber einem Kalibriernormal, an welchem die Kalibrierung der Messsonde durchgeführt wurde, kompensiert werden. Dies ermöglicht, dass Abweichungen in der Permeabilität des zu prüfenden Grundwerkstoffes des Messgegenstandes gegenüber dem Kalibriernormal eliminiert werden. Eine Kalibrierung der Messsonde ist für den zu messenden Grundwerkstoff des Messgegenstands nicht erforderlich.

Die während des Messvorganges erfassten Wechselwirkungsvolumen werden bevorzugt in einer Auswerteeinrichtung ausgewertet, und die korrigierte Schichtdicke wird insbesondere nach der Formel

$$d^{korr} = d^{mess} + \Delta d\big(\Delta d^{ia}, x_n^i\big)$$

ermittelt. Dabei ist die Größe $d^{mess}$ die gemessene Schichtdicke aus der normierten Zählrate $x_n^i$ der ersten und zweiten Spule des inneren Spulenpaares. Die Größe

$$\Delta d\big(\Delta d^{ia}, x_n^i\big)$$

ist eine zweidimensionale Permeabilitätskompensationsfunktion, welche sich aus den Schichtdickendifferenzen $\Delta d^{ia} = f(\mu_{rk}, x_{nk}^i)$ des äußeren und des inneren Spulenpaares ergibt, die für vorgegebene Permeabilitäten als Funktion der normierten Zählrate $x_n^i$ des ersten Spulenpaares beziehungsweise inneren Spulenpaares im Topfkern erfasst werden. Insbesondere ist die Kenntnis der Permeabilitäten nicht mehr erforderlich. Dadurch wird ermöglicht, dass durch die Permeabilitätskompensationsfunktion der Einfluss der tatsächlichen Permeabilität des Grundwerkstoffs eliminiert werden kann, um als Ergebnis die unverfälschte Schichtdicke auszugeben. Unter einer normierten Zählrate wird die Auswertung der normierten Spannung verstanden, wobei gilt $U_n = \frac{U - U_0}{U_\infty - U_0}$. Dabei ist $U_0$ diejenige Spannung, die entsteht, wenn die Sonde unmittelbar auf dem Grundwerkstoff aufgesetzt wird und eine zu messende Schicht auf dem Grundwerkstoff nicht vorhanden ist. $U_\infty$ ist diejenige Spannung, die bei abgehobener Messsonde entsteht, wobei der Abstand so groß ist, dass die Messsonde nicht mehr vom magnetisierbaren Grundwerkstoff beeinflusst wird. $U$ ist diejenige Spannung, die bei einem regulären Abstand, wie er bei den zu messenden Schichten auf einem Grundwerkstoff entsteht. Daraus ergibt sich, dass die normierte Spannung $U_n$ stets zwischen den Zahlen 0 und 1 liegt.

Alternativ können die während des Messvorgangs erfassten Wechselwirkungsvolumen in einer Auswerteeinrichtung dahingehend ausgewertet werden, dass die korrigierte Schichtdicke nach der Formel

$$d^{korr} = d^{mess} + \Delta d\big(\Delta x_n^{ia}, x_n^i\big)$$

ermittelt wird. Dabei ist die Größe $d^{mess}$ die gemessene Schichtdicke aus den normierten Zählraten des inneren Spulenpaares. Die Größe $\Delta d\big(\Delta x_n^{ia}, x_n^i\big)$ ist eine zweidimensionale Permeabilitätskompensationsfunktion, welche sich aus den Abweichungen der normierten Zählraten

$$x_n^{ia} = \mathrm{f}(\mu rk, x_{nk}^i)$$

des äußeren und des inneren Spulenpaares ergibt, die für variable Permeabilitäten des Grundwerkstoffes als Funktion der normierten Zählrate $x_n^i$ des ersten Spulenpaares erfasst werden. Bei dieser alternativen Ausführungsform kann somit die Permeabilitätskompensation auf Basis der Schichtdickenabweichung und der Abweichung der normierten Zählrate erfolgen. Insbesondere ist die Kenntnis der Permeabilitäten nicht mehr erforderlich.

Eine weitere alternative Auswertung des Messvorgangs in einer Auswerteeinrichtung sieht vor, dass diese ausschließlich auf Basis der Abweichungen der normierten Zählrate erfolgt. Die während des Messvorgangs erfassten Wechselwirkungsvolumen werden ausgewertet, und die korrigierte Schichtdicke wird nach der Formel

$$d^{korr} = f[x_n^{korr}]$$

ermittelt. Dabei wird die Größe $x_n^{korr}$ nach der Formel

$$x_n^{korr} = x_n^{mess} + \Delta x_n \left( \Delta x_n^{ia}, x_n^i \right)$$

ermittelt. Die Größe $x_n^{mess}$ ist die gemessene normierte Zählrate $x_n^i$ der ersten und zweiten Spule des inneren Spulenpaares. Die Größe

$$\Delta x_n \left( \Delta x_n^{ia}, x_n^i \right)$$

ist eine zweidimensionale Permeabilitätskompensationsfunktion für die Abweichungen der normierten Zählraten

$$x_n^{ia} = \mathrm{f}(\mu rk, x_{nk}^i)$$

des äußeren und des inneren Spulenpaares. Mit der korrigierten Zählrate kann die korrigierte Schichtdicke direkt aus der vorzugsweise zuvor durchgeführten Werkskalibrierung berechnet werden. Insbesondere ist die Kenntnis der Permeabilitäten nicht mehr erforderlich.

Des Weiteren ist bevorzugt vorgesehen, dass eine erste Grundkalibrierung für das erste und zweite Spulenpaar für mehrere unterschiedliche Permeabilitäten kalibriert wird. Dadurch können Schichtdickenabweichungen durch die Permeabilitätsänderung des Grundwerkstoffs systematisch erfasst und in einer Kalibrierung zugrundegelegt werden. Die festgestellten Schichtdickenabweichungen für das innere Spulenpaar stellen eine erste notwendige Informationskomponente für die Permeabilitätskompensation dar. Die zweite notwendige Informationskomponente für die Kompensation stellt die Schichtdickendifferenz der durch die Permeabilitätsabweichung unterschiedlich verfälscht gemessenen Schichtdicken des ersten und zweiten Spulenpaares für die Schichtdickenkompensationsfunktion dar. Durch die Verknüpfung dieser beiden Informationskomponenten kann der Permeabilitätseinfluss auf die Schichtdicke eliminiert werden.

Vorteilhafterweise werden das erste und zweite Spulenpaar aufeinanderfolgend angesteuert und betrieben, um die jeweilige Wechselwirkungsvolumen im zu messenden Grundwerkstoff zu erfassen, also die erzeugte Spannung zu ermitteln. Alternativ kann das erste und zweite Spulenpaar auch gleichzeitig betrieben werden.

Die der Erfindung zugrundeliegende Aufgabe wird des Weiteren durch eine Messvorrichtung gemäß Anspruch 8 mit einer Messsonde zur Messung der Dicke von nicht magnetisierbaren Schichten auf einem magnetisierbaren Grundwerkstoff gelöst, welche eine Messsonde mit einem Sondenkopf aufweist, der einen Topfkern mit einer ersten und einer zweiten Spule aufnimmt, die auf einer gemeinsamen geometrischen Achse liegen und ein erstes Spulenpaar bilden und mit einer in der gemeinsamen Achse angeordneten Aufsetzkalotte sowie einem zweiten Spulenpaar, welches außerhalb des Topfkernes und gemeinsam zur geometrischen Achse angeordnet ist sowie eine erste und eine zweite Spule aufweist. Durch eine solche Messvorrichtung ist ermöglicht, dass Kraftlinien des ersten Spulenpaares einen fokussierten Feldverlauf aufweisen, so dass im Grundwerkstoff ein Wechselwirkungsvolumen erzeugt wird, welches insbesondere im Bereich des Topfkernes fokussiert ist und somit eine hohe Felddichte aufweist. Das zweite Spulenpaar ist ohne eine Feldfokussierung betrieben, so dass dessen Wechselwirkungsvolumen auch weit außerhalb des Sondenkopfes liegt und somit ein deutlich größeres Wechselwirkungsvolumen des Grundwerkstoffes umfasst. Dies ermöglicht, dass Unterschiede im Wechselwirkungsvolumen durch das erste und zweite Spulenpaar ermittelt und variierende magnetische Eigenschaften des Grundwerkstoffes erfasst und kompensiert werden können.

Die Erfindung sowie weitere vorteilhafte Ausführungsformen und Weiterbildungen derselben werden im Folgenden anhand der in den Zeichnungen dargestellten Beispiele näher beschrieben und erläutert. Es zeigen:

Figur 1 eine schematische Schnittansicht einer ersten Ausführungsform einer Messsonde,
Figur 2 eine schematisch vergrößerte Ansicht eines erfindungsgemäßen Sondenkopfes der Messsonde gemäß Figur 1,
Figur 3 ein Diagramm zur Darlegung des Schichtdickenverlaufs als Funktion der normierten Zählrate $x_n$ des inneren Spulenpaares des Sondenkopfes für 3 unterschiedliche Permeabilitäten des Grundwerkstoffes,
Figur 4 ein schematisches Diagramm zur Darlegung der resultierenden Schichtdickenabweichung Dd einer Permeabilität $\mu_{r1}$ und $\mu_{r3}$ aus Figur 3,
Figur 5 ein schematisches Diagramm zur Darlegung des Schichtdickenverlaufs als Funktion der normierten Zählrate $x_n$ des inneren bzw. des äußeren Spulenpaares für 3 unterschiedliche Permeabilitäten des Grundwerkstoffes und der daraus resultierenden Schichtdickendifferenz Dd[ia] bei den Permeabilitäten $\mu_{r1}$ und $\mu_{r3}$, und
Figur 6 ein schematisches Diagramm zur Darlegung der Schichtdickendifferenz Dd[ia] zwischen den beiden Spulenpaaren für vorgegebene Permeabilitäten gemäß Figur 5 als Funktion der normierten Zählrate des ersten Spulenpaars.

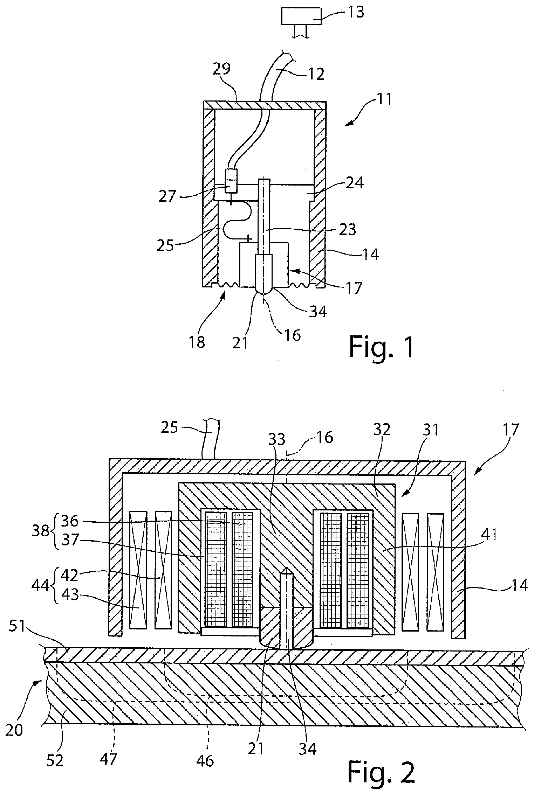

In Figur 1 ist schematisch eine Schnittansicht einer Messsonde 11 dargestellt. Der prinzipielle Aufbau dieser Messsonde 11 ist aus der DE 10 2005 054 593 A1 bekannt, auf welche vollumfänglich Bezug genommen wird. Die Messsonde 11 wird zur zerstörungsfreien Messung der Dicke von Schichten 51 auf einem Grundwerkstoff 52 eines Messgegenstands 20 eingesetzt. Diese Messsonde 11 ist über zumindest eine Verbindungsleitung oder Steuerleitung 12 mit einer Auswerteeinrichtung 13 verbunden, welche die erfassten Messsignale bearbeitet und auch an einem Display ausgeben kann. Die Messsonde 11 weist ein Gehäuse 14 auf, welches beispielsweise zylindrisch ausgebildet ist. In einer Längsachse 16 des nicht magnetisierbaren Gehäuses 14 ist ein Sondenkopf 17 angeordnet, der von einem Halteelement 18 getragen ist. Dieses Halteelement 18 ist als elastisch nachgiebiges Halteelement ausgebildet, insbesondere als eine Membran oder als ein Federelement. Der Sondenkopf 17 kann durch ein Führungselement 23 entlang der Längsachse 16 verschiebbar geführt werden, so dass der Sondenkopf 17 beim Aufsetzen der Messsonde 11 auf den Messgegenstand 20 geringfügig in das Gehäuse 14 eintauchen kann. Bevorzugt ist der Sondenkopf 17 durch das Führungselement 23 verkippungsfrei an einem gehäusefesten Lager 24 geführt. Elektrische Leitungen 25 des Sondenkopfes 17 sind mit einem Anschluss 27 der Leitung 12 verbunden, der vorzugsweise ebenfalls im Lager 24 befestigt ist.

Der Sondenkopf 17 weist in der Längsachse 16 liegend und zum Messgegenstand 20 weisend eine Aufsetzkalotte 21 auf.

Der Sondenkopf 17 kann auch in weitere abweichende konstruktive Ausgestaltungen von Messsonden 11 eingesetzt werden.

In Figur 2 ist eine schematisch vergrößerte Ansicht des Sondenkopfes 17 der Messsonde 11 gemäß Figur 1 dargestellt. Dieser Sondenkopf 17 umfasst einen Topfkern 31. Dieser Topfkern 31 ist bevorzugt aus einem Weicheisenmaterial ausgebildet. Im Topfkern 31 erstreckt sich vom Boden 32 des Topfkerns 31 ein Kern 33, an dessen freien Ende die Aufsetzkalotte 21 positioniert ist. Die Aufsetzkalotte 21 kann einen gehärteten Stift 34 aufweisen.

Im Topfkern 31 ist eine erste und zweite Spule 36, 37 angeordnet. Die erste und zweite Spule 36, 37 sind koaxial an einer gemeinsamen Längsachse 16 ausgerichtet und bilden ein erstes Spulenpaar 38. Das erste Spulenpaar 38 wird auch als inneres Spulenpaar bezeichnet.

Außerhalb einer radialen Umfangswand 41 des Topfkerns 31 ist des Weiteren eine erste und zweite Spule 42, 43 vorgesehen. Die erste und zweite Spule 42, 43 sind koaxial zueinander angeordnet und vorzugsweise zur Längsachse 16 ausgerichtet. Die erste und zweite Spule 42, 43 bilden ein zweites Spulenpaar 44, das auch als äußeres Spulenpaar bezeichnet wird.

Das äußere Spulenpaar 44 und der Topfkern 31 sind von dem Gehäuse 14 umgeben. Das Gehäuse 14 beeinflusst das magnetische Feld des äußeren Spulenpaars 44 nicht.

Die Spulen 36, 37, 42, 43 umfassen zumindest einen elektrischen Leiter, der mehrere Windungen umfasst und auf einem Spulenkörper aufgewickelt ist.

Der Sondenkopf 17 liegt mit der Aufsetzkalotte 21 zur Durchführung einer Messung auf dem beschichteten Messgegenstand 20 auf. Die Aufsetzkalotte 21 berührt eine nicht magnetisierbare Schicht 51 auf dem magnetisierbaren Grundwerkstoff 52. Die durch das erste Spulenpaar 38 erzeugten Kraftlinien weisen durch den Topfkern 31 eine Feldfokussierung auf, wodurch ein erstes vorzugsweise konzentriertes Wechselwirkungsvolumen 46 im Grundwerkstoff 52 erzeugt wird. Das zweite Spulenpaar 44 erfährt keine Feldfokussierung der Kraftlinien, wodurch ein gegenüber dem ersten Wechselwirkungsvolumen 46 vergrößertes Wechselwirkungsvolumen 47 des Grundwerkstoffs 52 erzeugt wird.

Zur Durchführung einer Messung der Schichtdicken wird die erste Spule 36 des ersten Spulensystems beispielsweise mit einem niederfrequenten Strom periodisch angeregt. Diese erste Spule 36 wird auch als Primärspule bezeichnet. Dadurch wird in der zweiten Spule 37 oder Sekundärspule eine Spannung induziert, deren Größe von der Frequenz und Amplitude des Anregungsstromes der ersten Spule 36 sowie von der Kopplung in Abhängigkeit des Wechselwirkungsvolumens der ersten und zweiten Spule 36, 37 abhängt. Die Kopplung der ersten und zweiten Spule 36, 37 ist wiederum abhängig vom magnetischen Fluss B, der beide Spulen 36, 37 durchdringt. Der magnetische Fluss wird wiederum neben dem Anregungsstrom auch durch den magnetischen Widerstand des Umgebungsmaterials der Spulen 36, 37 bestimmt. Wird die Messsonde 11 auf dem magnetisierbaren Grundwerkstoff 52 aufgesetzt, erhöht sich der magnetischen Fluss B, weil der Grundwerkstoff 52 dem Feldverlauf einen deutlich geringeren magnetischen Widerstand als Luft entgegensetzt im Gegensatz zur Situation, wenn der Sondenkopf 17 vom Grundwerkstoff 52 abgehoben ist. Dies führt zur Erhöhung des Koppelfaktors der ersten und zweiten Spule 36, 37 und damit zu einer Zunahme der induzierten Spannung. Sofern der Abstand zwischen dem Sondenkopf 17 und dem Grundwerkstoff 52 erhöht wird, reduziert sich die induzierte Spannung in der Sekundärspule. Damit hängt die messbare induzierte Spannung vom Abstand zum Grundwerkstoff 52 ab, also der Schichtdicke der Schicht 51, und kann über eine Kalibrierung zur Schichtdickenmessung verwendet werden. Analoges gilt auch für das zweite Spulenpaar 44.

Durch die beim ersten Spulenpaar 38 vorgesehene Feldfokussierung und die beim zweiten Spulenpaar 44 nicht gegebene Feldfokussierung werden die verschiedenen Wechselwirkungsvolumen 46, 47 des Grundwerkstoffes 52 erfasst. Diese resultierenden Unterschiede auf das erste und zweite Spulenpaar 38, 44 können für variierende magnetisierbare Eigenschaften des Grundwerkstoffes 52 beim Messen erfasst und für eine Kompensation der Permeabilität des Grundwerkstoffs 52 genutzt werden. Die Dicke der Schicht 51 kann ohne tatsächliche Kenntnis der Permeabilität des mit der Schicht 51 beschichteten Grundwerkstoffs 52 ermittelt werden. Dies wird nachfolgend erörtert:

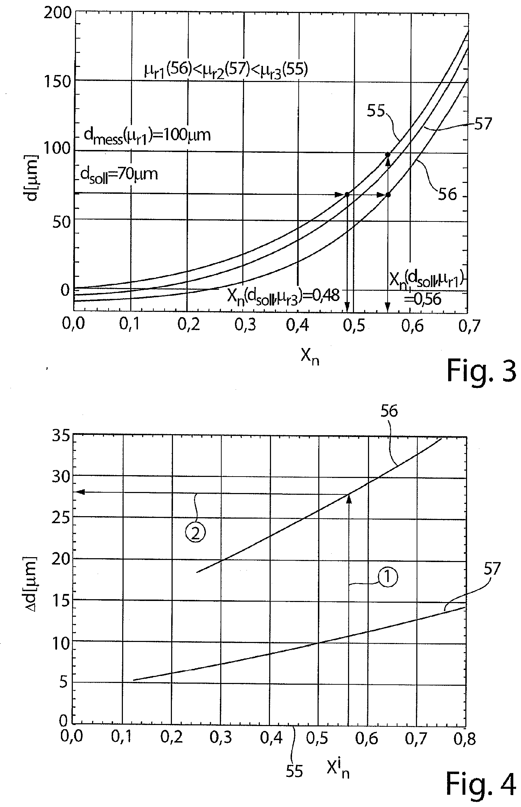

Figur 3 zeigt ein Diagramm, bei welchem verschiedene Kennlinien 55, 56, 57 für Schichtdicken d als Funktion von normierten Messsignalen $x_n$ in Abhängigkeit von einem definierten Grundwerkstoff aufgetragen sind. Eine Kennlinie 55 ist durch eine Kalibrierung der Messsonde 11 auf einen definierten Grundwerkstoff, beispielsweise $\mu_{r3}$, bestimmt und in der Messsonde 11 beziehungsweise der Auswerteeinrichtung 13 in Form von Koeffizienten abgespeichert. Wird diese Messsonde 11 nunmehr zur Messung auf einem Grundwerkstoff 52 mit einer davon abweichenden Permeabilität verwendet, ändert sich der Kennlinienverlauf. Beispielsweise ergibt sich für eine Permeabilität $\mu_{r1}$ die Kennlinie 56, und für die Permeabilität $\mu_{r2}$ ergibt sich die Kennlinie 57. Dabei gilt, dass $\mu_{r1}$ kleiner $\mu_{r2}$ und $\mu_{r2}$ kleiner $\mu_{r3}$ ist. Sofern die Sollschichtdicke $d_{soll}$ gleich 70 $\mu$m auf dem kalibrierten Grundwerkstoff 52 ist, resultiert daraus beispielsweise ein Messwert von 0,48. Bedingt durch die Änderung der Permeabilität des Grundwerkstoffs 52 wird stattdessen bei einer Permeabilität $\mu_{r1}$ der Messwert 0,56 ermittelt. Die Berechnung der Dicke mit der verwendeten Kalibrierkennlinie 55 resultiert damit aber in einer verfälschten Schichtdicke von $d_{mess}$ gleich 100 $\mu$m. Somit resultiert die beschriebene Schichtdickenabweichung $\Delta d$ ($\mu_r$) durch die Permeabilitätsänderung des Grundwerkstoffs. Diese kann systematisch in einer Kalibrierung mit vorgegebenen und verschiedenen Permeabilitäten bestimmt und erfasst werden. Dadurch wird eine erste notwendige Informationskomponente für eine Kompensation der Permeabilität bei der Ermittlung einer korrigierten Schichtdicke erfasst.

In Figur 4 ist ein Diagramm dargestellt, bei welchem eine Schichtdickenabweichung $\Delta d$ als Funktion des normierten Messsignals $x_n$ aufgetragen ist. Diese Schichtdickenabweichungen sind für die Permeabilität $\mu_{r1}$ und $\mu_{r2}$ aus Figur 4 dargestellt. Dadurch ergibt sich für den Fall der ursprünglichen Kalibrierung gemäß der Kennlinie 55 eine Linie, die in der X-Achse liegt, wohingegen sich für die Permeabilität $\mu_{r2}$ die Kennlinie 57 und für $\mu_{r1}$ die Kennlinie 56 ergibt. Dieses Diagramm zeigt die Schichtdickenabweichungen beim ersten Spulenpaar 38. Daraus ergibt sich, dass für eine Permeabilität $\mu_{r1}$ ausgehend vom Wert 0,56 gemäß Figur 3 eine Schichtdickenabweichung von beispielsweise 28 $\mu$m und im Fall $\mu_2$ eine Schichtdickenabweichung von beispielsweise 11 $\mu$m ergibt. Die gilt es zu korrigieren.

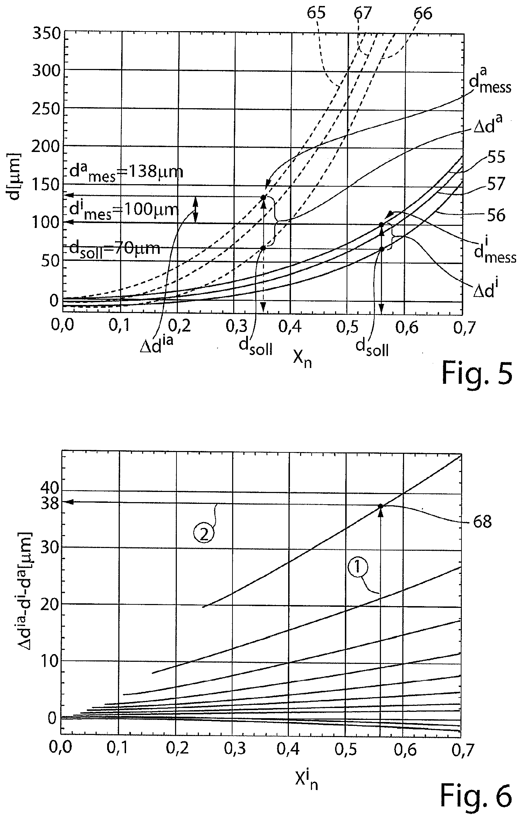

Sofern nun das erste und zweite Spulenpaar 38, 44 separat betrachtet werden, ergeben sich unterschiedliche Kennlinienverläufe, wie dies im Diagramm gemäß Figur 5 dargestellt ist. Die Kennlinien 55, 56 und 57 für das erste beziehungsweise innere Spulenpaar 38 weicht wiederum von den korrespondierenden Kennlinien 65, 66 und 67 des zweiten Spulenpaars 44 beziehungsweise dem äußeren Spulenpaar ab. Daraus geht beispielsweise auch hervor, dass durch einen Vergleich der beiden Messpunkte, beispielsweise bei $x_n$ von 0,35 für das Spulenpaar 44 und bei $x_n$ von 0,56 für das Spulenpaar 38 die ermittelte Schichtdicke zwischen dem inneren und äußeren Spulenpaar 38, 44 eine Differenz von $\Delta d^{ia}$ von beispielsweise 38 $\mu$m (siehe Punkt 68 in Figur 6) ergeben.

Zur Bestimmung der Permeabilität aus den unterschiedlichen Abhängigkeiten des ersten Spulenpaars 38 und zweiten Spulenpaars 44 kann gemäß Figur 6 eine Differenz $\Delta d^{ia}$ des ersten und zweiten Spulenpaars 38, 44 als Funktion der normierten Zählrate des ersten Spulenpaars 38 betrachtet werden. Diese Abhängigkeit $\Delta d^{ia}$ in Bezug auf die Permeabilität des Grundwerkstoffes 52 entspricht der zweiten notwendigen Informationskomponente für die Kompensation der Permeabilität des sich beispielsweise als Funktion der normierten Zählrate $x_n$ des inneren Spulenpaars 38 beschreiben

ben $\Delta d_k \left( \mu rk \, x_{nk}^{\,i} \right) = f(\mu rk, \, x_{nk}^{\,i})$. Diese Funktion lässt sich nach $\mu_r$ auflösen und in die Funktion der Schichtdickenabweichung einsetzen. Dadurch lässt sich der Parameter der Permeabilität eliminieren und die gesuchte Schichtdicken-abweichung $\Delta d$ ist nur noch eine Funktion der zugänglichen Messgrößen $\Delta d^{ia}$ und $x_n^i$. Daraus ergibt sich eine zwei-parametrige Permeabilitätskompensationsfunktion $\Delta d = f\left(\Delta d^{ia};\ x_n^i\right)$.

Daraus ergibt sich dann eine korrigierte Schichtdicke $d^{korr} = d^{mes} + \Delta d\left(\Delta d^{ia}, x_n^i\right)$. Bei der korrigierten Schichtdicke handelt es sich somit um ein um den Permeabilitätseinfluss bereinigte Schichtdicke, die gemessen werden kann, ohne dass die exakte Permeabilität des Grundwerkstoffs 52 bekannt ist oder gemessen werden muss.

Durch eine solche Auswertung und Erfassung der Messsignale ist ermöglicht, dass die auf eine vorbestimmte Permeabilität kalibrierte Messsonde 11 auf dem Messgegenstand 20 mit unbekannter Schichtdicke und unbekanntem Grundwerkstoff 52 aufgesetzt wird. Die Auswerteeinrichtung 13 ermittelt die normierten Zählraten $x_n$ des ersten und zweiten Spulenpaars 38, 44. Daraus werden über die Schichtdickenkalibrierfunktion der Messsonde 11 die dazugehörigen verfälschten Schichtdicken $d_i$ beziehungsweise $d_a$ berechnet und daraus die interne Größe der Schichtdickendifferenz $\Delta d^{ia}$. Aus der zweidimensionalen Permeabilitätskompensationsfunktion

$$\Delta d\left(\Delta d^{ia}, x_n^i\right)$$

kann dann die dem Messwert erforderliche Korrektur hinzugefügt werden, so dass der Permeabilitätseinfluss kompensiert ist.

## Patentansprüche

1. Verfahren zur Messung der Dicke von nicht magnetisierbaren Schichten (51) auf einem magnetisierbaren Grundwerkstoff (52), dessen Permeabilität nicht bekannt ist, mit einer Messsonde (11), welche einen Sondenkopf (17) aufweist, der einen Topfkern (31) mit einer ersten und zweiten Spule (36, 37) umfasst, die auf einer gemeinsamen Längsachse (16) liegen und bei dem die erste und zweite Spule (36, 37) ein erstes Spulenpaar (38) bilden, und der in der gemeinsamen Längsachse (16) eine Aufsetzkalotte (21) aufweist,

    - bei welchem zur Messung der Dicke der Schicht (51) auf dem Grundwerkstoff (52) der Sondenkopf (17) auf der Schicht (51) aufgesetzt wird,
    - wobei durch das erste Spulenpaar (38) mit einer durch den Topfkern (31) bewirkten Feldfokussierung ein erstes Wechselwirkungsvolumen erfasst wird,
    **dadurch gekennzeichnet**
    - **dass** durch ein zweites Spulenpaar (44) mit einer ersten und zweiten Spule (42, 43), welches außerhalb des Topfkerns (31) und gemeinsam und koaxial zur Längsachse (16) angeordnet ist, ohne Feldfokussierung durch den Topfkern (31) ein zweites Wechselwirkungsvolumen erfasst wird, und
    - **dass** das erfasste erste und zweite Wechselwirkungsvolumen in einer Auswerteeinrichtung (13) verarbeitet und zur Kompensation einer Permeabilität des Grundwerkstoffes (52), auf dem die zu messende Schicht (51) aufgebracht ist, miteinander verglichen werden und eine Schichtdicke für die gemessene Schicht (51) ausgegeben wird, welche um den Einfluss der Permeabilität des Grundwerkstoffs (52) korrigiert ist.

2. Verfahren nach Anspruch 1, **dadurch gekennzeichnet,**

    - **dass** das während des Messvorganges erfasste Wechselwirkungsvolumen ausgewertet und die korrigierte Schichtdicke nach der Formel

$$d^{korr} = d^{mess} + \Delta d\left(\Delta d^{ia}, x_n^i\right)$$

    ermittelt wird,
    - wobei die Größe $d^{mess}$ die gemessene Schichtdicke aus den normierten Zählraten der ersten und zweiten Spule (36, 37) des ersten Spulenpaares (38) ist und wobei

$$\Delta d\left(\Delta d^{ia}, x_n^i\right)$$

eine zweidimensionale Permeabilitätsfunktion ist, welche sich aus den Schichtdickenabweichungen $\Delta d^{ia}$ zwischen dem ersten Spulenpaar (38) und dem zweiten Spulenpaar (44) ergibt, die für variable Permeabilitäten des Grundwerkstoffs (52) als Funktion der normierten Zählrate $x_n^i$ des ersten Spulenpaares (38) verwendet wird.

3. Verfahren nach Anspruch 1, **dadurch gekennzeichnet,**

   - **dass** das während des Messvorganges erfasste Wechselwirkungsvolumen ausgewertet und die korrigierte Schichtdicke nach der Formel $d^{korr} = d^{mess} + \Delta d\left(\Delta x_n^{ia}, x_n^i\right)$ ermittelt wird,
   - wobei die Größe $d^{mess}$ die gemessene Schichtdicke aus den normierten Zählraten der ersten und zweiten Spule (36, 37) des ersten Spulenpaares (38) ist und wobei

$$\Delta d\left(\Delta x_n^{ia}, x_n^i\right)$$

eine zweidimensionale Permeabilitätsfunktion ist, welche sich aus den Abweichungen der normierten Zählraten $\Delta x_n^{ia}$ zwischen dem ersten Spulenpaar (38) und dem zweiten Spulenpaar (44) ergibt, die für variable Permeabilitäten des Grundwerkstoffs (52) als Funktion der normierten Zählrate $x_n^i$ des ersten Spulenpaares (38) verwendet wird.

4. Verfahren nach Anspruch 1, **dadurch gekennzeichnet,**

   - **dass** das während des Messvorgangs erfasste Wechselwirkungsvolumen ausgewertet und die korrigierte Schichtdicke nach der Formel

$$d^{korr} = f\left[x_n^{korr}\right]$$

ermittelt wird,

wobei die Größe $x_n^{korr}$ nach der Formel $x_n^{korr} = x_n^{mess} + \Delta x_n\left(\Delta x_n^{ia}, x_n^i\right)$ ermittelt wird, und die Größe $x_n^{mess}$ die gemessene normierte Zählraten der ersten und zweiten Spule (36, 37) ist und wobei

$$\Delta x_n\left(\Delta x_n^{ia}, x_n^i\right)$$

eine zweidimensionale Permeabilitätskompensationsfunktion ist, welche sich aus den Abweichungen der normierten Zählraten $\Delta x_n^{ia}$ ergibt, die für variable Permeabilitäten des Grundwerkstoffs (52) als Funktion der normierten Zählrate $x_n^i$ des ersten Spulenpaares (38) verwendet wird.

5. Verfahren nach einem der Ansprüche 2 bis 4, **dadurch gekennzeichnet, dass** die Kenntnis der jeweiligen Permeabilität nicht erfordert wird.

6. Verfahren nach einem der vorhergehenden Ansprüche, **dadurch gekennzeichnet, dass** eine erste Grundkalibrierung für das erste und zweite Spulenpaar (38, 44) vor der Durchführung von Messungen zur Ermittlung einer Schichtdicke auf mehrere unterschiedliche Permeabilitäten von Grundwerkstoffen (52) durchgeführt wird.

7. Verfahren nach einem der vorhergehenden Ansprüche, **dadurch gekennzeichnet, dass** das erste und zweite Spulenpaar (38, 44) aufeinanderfolgend oder gleichzeitig zur Erfassung des Wechselwirkungsvolumens angesteuert werden.

8. Messvorrichtung zur Messung der Dicke von nicht magnetisierbaren Schichten (51) auf einem magnetisierbaren Grundwerkstoff (52), wobei die Messvorrichtung zur Durchführung des Verfahrens nach einem der Ansprüche 1 bis 7 eingerichtet ist, mit einer Messsonde (11), welche einen Sondenkopf (17) aufweist, der einen Topfkern (31) mit einer ersten und einer zweiten Spule (36, 37) aufweist, die auf einer gemeinsamen Längsachse (16) liegen und die erste und zweite Spule (36, 37) ein erstes Spulenpaar (38) bilden und mit einer in der gemeinsamen Längsachse (16) angeordneten Aufsetzkalotte (21) und mit einer Auswerteeinrichtung (13), **dadurch gekennzeichnet, dass** außerhalb des Topfkerns (31) und gemeinsam zur Längsachse (16) ein zweites Spulenpaar (44) mit einer ersten und zweiten Spule (42, 43) vorgesehen ist, welche koaxial zur Längsachse (16) ausgerichtet sind.

**Claims**

1. Method for measuring the thickness of nonmagnetisable layers (51) on a magnetisable base material (52), the permeability of which is not known, having a measuring probe (11), which has a probe head (17), which comprises a pot core (31) having a first and second coil (36, 37), which lie on a common longitudinal axis (16), and in which the first and second coil (36, 37) form a first coil pair (38), and which has a bearing calotte (21) in the common axis (16),

   - in which, in order to measure the thickness of the layer (51) on the base material (52), the probe head (17) is placed on the layer (51),
   - wherein a first interaction volume is detected by the first coil pair (38) with a field focusing caused by the pot core (31),
   **characterised in that**
   - that a second interaction volume is detected by a second coil pair (44) having a first and second coil (42, 43), which is arranged outside the pot core (31) and jointly with the longitudinal axis (16) without field focusing by the pot core (31), and
   - that the detected first and second interaction volumes are processed in an evaluation device (13) and compared to each other to compensate for a permeability of the base material (52), on which the layer (51) to be measured is applied, and a layer thickness is output for the measured layer (51), which is corrected by the influence of the permeability of the base material (52).

2. Method according to claim 1, **characterised in that**

   - the interaction volume detected during the measuring process is evaluated, and the corrected layer thickness is determined according to the formula $d^{korr} = d^{mess} + \Delta d\left(\Delta d^{ia}, x_n^i\right)$,
   - wherein the size $d^{mess}$ is the measured layer thickness from the normalised count rates of the first and second coil (36, 37) of the first coil pair (38), and wherein $\Delta d\left(\Delta d^{ia}, x_n^i\right)$ is a two-dimensional permeability function, which emerges from the layer thickness deviations $\Delta d^{ia}$ between the first coil pair (38) and the second coil pair (44), which are used for variable permeabilities of the base material (52) as a function of the normalised count rate $x_n^i$ of the first coil pair (38.

3. Method according to claim 1, **characterised in that**

   - the interaction volume detected during the measuring process is evaluated, and the corrected layer thickness is determined according to the formula $d^{korr} = d^{mess} + \Delta d\left(\Delta x_n^{ia}, x_n^i\right)$,

   - wherein the size $d^{mess}$ is the measured layer thickness from the normalised count rates of the first and second coil (36, 37) of the first coil pair (38), and wherein $\Delta d\left(\Delta x_n^{ia}, x_n^i\right)$ is a two-dimensional permeability function, which emerges from the layer thickness deviations $\Delta x_n^{ia}$ between the first coil pair (38) and the second coil pair (44), which are used for variable permeabilities of the base material (52) as a function of the normalised count rate $x_n^i$ of the first coil pair (38.

4.  Method according to claim 1, **characterised in that**

- the interaction volume detected during the measuring process is evaluated, and the corrected layer thickness is determined according to the formula $d^{korr} = f[x_n^{korr}]$ ,

- wherein the size $x_n^{korr}$ is determined according to the formula

$$x_n^{korr} = x_n^{mess} + \Delta x_n \left( \Delta x_n^{ia}, x_n^i \right)$$ , and the size $x_n^{mess}$ is the measured normalised count rates of the first and second coil (36, 37), and wherein $\Delta x_n \left( \Delta x_n^{ia}, x_n^i \right)$ is a two-dimensional permeability compensation function, which emerges from the deviations of the normalised count rates $\Delta x_n^{ia}$ , which is used for the variable permeabilities of the base material (52) as a function of the normalised count rate $x_n^i$ of the first coil pair (38).

5.  Method according to the claims 2 to 4, **characterised in that** knowledge of the respective permeability is not required.

6.  Method according to one of the preceding claims, **characterised in that** a first base calibration for the first and second coil pair (38, 44) is carried out before carrying out measurements to determine a layer thickness on several different permeabilities of base materials (52).

7.  Method according to one of the preceding claims, **characterised in that** the first and second coil pair (38, 44) are controlled one after the other or simultaneously for detecting the interaction volume.

8.  Measuring device for measuring the thickness of nonmagnetisable layers (51) on a magnetisable base material (52), wherein the measuring device is provided for carrying out the method according to one of claims 1 to 7, having a measuring probe (11), which has a probe head (17), which has a pot core (31) having a first and a second coil (36, 37), which lie on a common longitudinal axis (16), and the first and second coil (36, 37) form a first coil par (38), and having a bearing calotte (21) arranged in the common longitudinal axis (16) and with an evaluation device (13), **characterised in that** a second coil pair (44) having a first and second coil (42, 43) is provided outside the pot core (31) and jointly with the longitudinal axis (16), said coils (42, 43) being aligned coaxially to the longitudinal axis (16).

**Revendications**

1.  Procédé destiné à mesurer l'épaisseur de couches (51) non magnétisables sur un matériau de base (52) magnétisable dont la perméabilité n'est pas connue, et ce grâce à une sonde de mesure (11) présentant une tête de sonde (17) qui comprend un noyau en pot (31) constitué d'une première et d'une deuxième bobine (36, 37) situées sur un axe longitudinal (16) commun et dans laquelle la première et la deuxième bobine (36, 37) forment une première paire de bobines (38) et qui présente une calotte de positionnement (21) dans ledit axe longitudinal (16) commun,

- lors duquel, en vue de mesurer l'épaisseur de la couche (51) sur le matériau de base (52), la tête de sonde (17) est posée sur la couche (51),
- un premier volume d'interaction étant saisi par la première paire de bobines (38) grâce à une focalisation de champ créée par le noyau en pot (31),
**caractérisé en ce que**
- un deuxième volume d'interaction est saisi, sans focalisation de champ crée par le noyau en pot (31), par une deuxième paire de bobines (44) constituée d'une première et d'une deuxième bobine (42, 43), laquelle est disposée à l'extérieur du noyau en pot (31), et ce ensemble et de manière coaxiale audit axe longitudinal (16), et
- le premier et le deuxième volume d'interaction saisis sont traités dans un dispositif d'interprétation (13) et sont comparés l'un à l'autre en vue de compenser une perméabilité du matériau de base (52) sur lequel est appliquée la couche (51) à mesurer, et **en ce qu'**une épaisseur de couche pour la couche (51) à mesurer est sortie, laquelle est corrigée en tenant compte de l'influence exercée par la perméabilité du matériau de base (52).

**2.** Procédé selon la revendication 1, **caractérisé en ce que**

- le volume d'interaction saisi pendant le processus de mesure est interprété et l'épaisseur de couche corrigée est déterminée selon la formule

$$d^{korr} = d^{mess} + \Delta d\left(\Delta d^{ia}, x_n^i\right),$$

- la grandeur $d^{mess}$ étant l'épaisseur de couche mesurée à partir des taux de comptage normés de la première et de la deuxième bobine (36, 37) constituant la première paire de bobines (38), et

$$\Delta d\left(\Delta d^{ia}, x_n^i\right)$$

étant une fonction de perméabilité bidimensionnelle qui résulte des différences d'épaisseurs de couche $\Delta d^{ia}$ entre la première paire de bobines (38) et la deuxième paire de bobines (44) et qui est utilisée pour des perméabilités variables du matériau de base (52) en tant que fonction du taux de comptage normé $x_n^i$ de la première paire de bobines (38).

**3.** Procédé selon la revendication 1, **caractérisé en ce que**

- le volume d'interaction saisi pendant le processus de mesure est interprété et l'épaisseur de couche corrigée est déterminée selon la formule

$$d^{korr} = d^{mess} + \Delta d\left(\Delta x_n^{ia}, x_n^i\right),$$

- la grandeur $d^{mess}$ étant l'épaisseur de couche mesurée à partir des taux de comptage normés de la première et de la deuxième bobine (36, 37) constituant la première paire de bobines (38), et

$$\Delta d\left(\Delta x_n^{ia}, x_n^i\right)$$

étant une fonction de perméabilité bidimensionnelle qui résulte des différences des taux de comptage normés $\Delta x_n^{ia}$ entre la première paire de bobines (38) et la deuxième paire de bobines (44) et qui est utilisée pour des perméabilités variables du matériau de base (52) en tant que fonction du taux de comptage normé $x_n^i$ de la première paire de bobines (38).

**4.** Procédé selon la revendication 1, **caractérisé en ce que**

- le volume d'interaction saisi pendant le processus de mesure est interprété et l'épaisseur de couche corrigée est déterminée selon la formule

$$d^{korr} = \int \left[ x_n^{korr} \right],$$

la grandeur $x_n^{korr}$ étant déterminée selon la formule $x_n^{korr} = x_n^{mess} + \Delta x_n \left( \Delta x_n^{ia}, x_n^{i} \right)$, et la grandeur $x_n^{mess}$ étant les taux de comptage normés mesurés de la première et de la deuxième bobine (36, 37), et

$$\Delta x_n \left( \Delta x_n^{ia}, x_n^{i} \right)$$

étant une fonction de compensation de perméabilité bidimensionnelle qui résulte des différences des taux de comptage normés $\Delta x_n^{ia}$ et qui est utilisée pour des perméabilités variables du matériau de base (52) en tant que fonction du taux de comptage normé $x_n^{i}$ de la première paire de bobines (38).

5. Procédé selon l'une quelconque des revendications 2 à 4, **caractérisé en ce que** la perméabilité respective n'a pas besoin d'être connue.

6. Procédé selon l'une quelconque des revendications précédentes, **caractérisé en ce qu'**une première calibration de base pour la première et la deuxième paire de bobines (38, 44) est effectuée avant la réalisation de mesures destinées à déterminer une épaisseur de couche appliquée sur plusieurs matériaux de base (52) de perméabilité différente.

7. Procédé selon l'une quelconque des revendications précédentes, **caractérisé en ce que** la première et la deuxième paire de bobines (38, 44) sont activées de manière successive ou de manière simultanée en vue de saisir le volume d'interaction.

8. Dispositif de mesure destiné à mesurer l'épaisseur de couches (51) non magnétisables sur un matériau de base (52) magnétisable, le dispositif de mesure étant conçu pour réaliser le procédé selon l'une quelconque des revendications 1 à 7, pourvu d'une sonde de mesure (11) qui présente une tête de sonde (17) présentant un noyau en pot (31) constitué d'une première et d'une deuxième bobine (36, 37) qui sont située sur un axe longitudinal (16) commun, et la première et la deuxième bobine (36, 37) formant une première paire de bobines (38), et pourvu d'une calotte de positionnement (21) disposée dans ledit axe longitudinal (16) commun, et pourvu d'un dispositif d'interprétation (13), **caractérisé en ce qu'**à l'extérieur du noyau en pot (31), et ce ensemble par rapport à axe longitudinal (16), est prévue une deuxième paire de bobines (44) constituée d'une première et d'une deuxième bobine (42, 43) qui sont orientées de manière coaxiale à l'axe longitudinal (16).

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3331407 C2
- DE 102005054593 A1
- DE 4119903 A1
- DE 4325767 A1
- DE 2410047 A1
- US 5648721 A
- DE 60018341 T2
- JP H11142577 A
- DE 19628220 A1
- GB 645777 A